# EUROPEAN PATENT APPLICATION

(11) **EP 3 780 075 A1**
(43) Date of publication of application: **17.02.2021**
(21) Application number: 20197731.1
(22) Date of filing: 16.08.2012
(51) Int. Cl.: H01L 21/56, H01L 27/146, H01L 31/0203, H01L 21/60, H01L 23/485, H01L 23/31

(54) **SENSING DEVICE PACKAGE STRUCTURE**

(30) Priority: 25.05.2012 TW 101118729
(62) Divisional of application: 12180711.9
(71) Applicant: Unimicron Technology Corp., Taoyuan City 333 (TW)
(72) Inventor: CHEN, Tsung-Yuan, 330 Taoyuan County (TW); CHENG, Wei-Ming, 807 Kaohsiung City (TW)
(74) Representative: Becker, Eberhard

(57) **Abstract**

A sensing device package structure including a middle dielectric layer, a sensing device, a front dielectric layer, a front patterned conductive layer and at least one front conductive via is provided. The middle dielectric layer has an anterior surface, a posterior surface and a middle opening. The sensing device is disposed in the middle opening. The sensing device has a front surface, a back surface, a sensing region, a blocking pattern, and at least one electrode. The front dielectric layer is disposed on the anterior surface of the middle dielectric layer and the front surface of the sensing device. The front dielectric layer has a front opening exposed the sensing region and the blocking pattern. The front patterned conductive layer is disposed on the front dielectric layer. The front conductive via penetrates through the front dielectric layer and connects the front patterned conductive layer and the electrode.

## Description

### BACKGROUND OF THE INVENTION

### 1. Field of the Invention

The invention relates to a device package structure and a method of fabricating the same, and more particularly, to a sensing device package structure and a method of fabricating the same.

### 2. Description of Related Art

In recent years, as electronic techniques develop rapidly and hi-tech electronic industries come into being in succession, more user-friendly electronic products with better functions are continuously progressing and advancing. Circuit boards are generally disposed to install sensing devices thereon in these electronic products. As the electronic products are continued heading towards the design trend of being light, thin, short, and having a small volume, hence, the thickness of circuit boards is developing towards thinner.

However, in the conventional techniques, firstly, manufacturers respectively fabricate a sensing device and a circuit board for carrying electronic devices. Afterwards, the sensing device is packaged on the circuit board to form a sensing device package structure. Such method not only requires more labor and more time, the overall thickness of the sensing device package structure may not be reduced easily. According to the above described, developing a method capable of fabricating a thinner sensing device package structure is one of the objectives that researchers are intended to achieve.

### SUMMARY OF THE INVENTION

The invention is directed to a method for fabricating a sensing device package structure with small volume and thin overall thickness.

The invention is directed to a sensing device package structure, which has thin overall thickness and small volume.

An embodiment of the invention provides a sensing device package structure, which comprises a middle dielectric layer, a sensing device, a front dielectric layer, a front patterned conductive layer and at least a front conductive via. The middle dielectric layer has an anterior surface, a posterior surface opposite to the anterior surface and a middle opening connecting with the anterior surface and the posterior surface. The sensing device is disposed in the middle opening. The sensing device has a front surface, a back surface opposite to the front surface, a sensing region located at the front surface, a blocking pattern located at the front surface and surrounded the sensing region, and at least one electrode located at the front surface and outside the blocking pattern. The front dielectric layer is disposed on the anterior surface of the middle dielectric layer and the front surface of the sensing device. The front dielectric layer has a front opening exposed the sensing region and the blocking pattern. The front patterned conductive layer is disposed on the front dielectric layer. The front conductive via penetrates through the front dielectric layer and connects the front patterned conductive layer and the electrode.

An embodiment of the invention provides a method for fabricating a sensing device package structure, which comprises the following steps. An adhesive layer and a middle dielectric layer disposed on the adhesive layer are provided, the middle dielectric layer has a middle opening and the middle opening exposes parts of the adhesive layer. A front surface of the sensing device is adhered on the adhesive layer to position the sensing device in the middle opening, wherein the sensing device has a sensing region located at the front surface, a blocking pattern located at the front surface and surrounded the sensing region, and at least one electrode located at the front surface and outside the blocking pattern. A back dielectric layer is formed on the posterior surface of the middle dielectric layer and a back surface opposite to the front surface of the sensing device to fix the sensing device in the middle opening of the middle dielectric layer. The adhesive layer is patterned to form a patterned adhesive layer, wherein the patterned adhesive layer covers the sensing region and least parts of the blocking pattern, and exposes the electrode and the middle dielectric layer. A front dielectric layer is formed on the anterior surface of the middle dielectric layer, the front surface of the sensing device and the patterned adhesive layer, but the front dielectric layer is blocked by the blocking pattern and the patterned adhesive layer, and thus the sensing region of the sensing device is not covered. At least one front conductive via penetrating through the front dielectric layer is formed to connect to the electrode. A front patterned conductive layer is formed on the front dielectric layer to connect the front conductive via. A laser is utilized to divide the front dielectric layer and the patterned adhesive layer along the blocking pattern. The patterned adhesive layer and the parts of the front dielectric layer thereon are removed to expose the sensing region.

According to the above description, the method of the invention may fabricate a sensing device package structure with thin overall thickness and small volume by embedding the sensing device within the middle dielectric layer. In addition, the blocking pattern surrounded the sensing region of the sensing device is utilized to avoid the sensing region of the sensing device being damaged easily during the subsequent fabrication process, thereby improving the production yield of the sensing device package structure.

In order to make the features and advantages of the present invention more comprehensible, the present invention is further described in detail in the following with reference to the embodiments and the accompanying drawings.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A to FIG. 1J are schematic cross-sectional views of a method for fabricating a sensing device package structure according to an embodiment of the invention.
FIG. 2 is a schematic top view illustrating the sensing device of FIG. 1A.

### DESCRIPTION OF THE EMBODIMENTS

### Method for fabricating a sensing device package structure

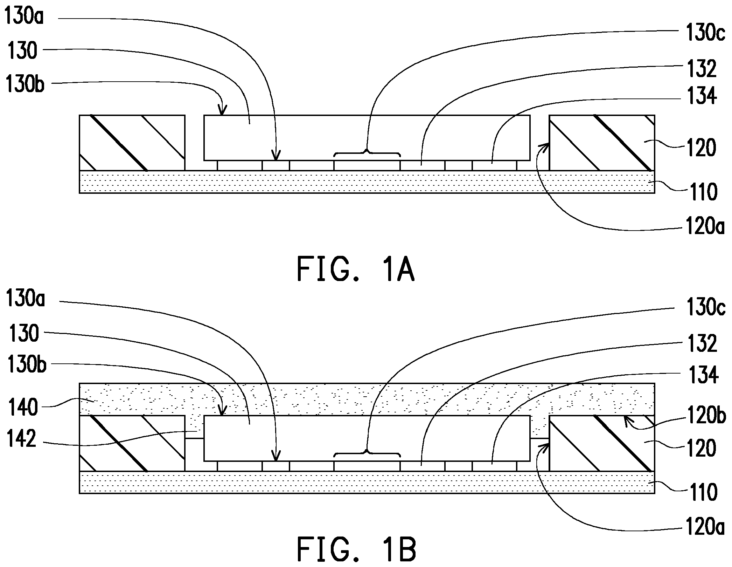

FIG. 1A to FIG. 1J are schematic cross-sectional views of a method for fabricating a sensing device package structure according to an embodiment of the invention. Referring to FIG. 1A to begin with, firstly, an adhesive layer 110 and a middle dielectric layer 120 disposed on the adhesive layer 110 are provided. The middle dielectric layer 120 has a middle opening 120a. The middle opening 120a exposes parts of the adhesive layer 110. In the embodiment, the shape and size of the middle opening 120a may depend on the shape and size of a sensing device intended to be disposed in the middle opening 120a, the invention does not limit the shape or size of the middle opening. The material of the middle dielectric layer 120 in the embodiment may comprise a high molecular polymer and a reinforcing fiber, but the invention is not limited thereto.

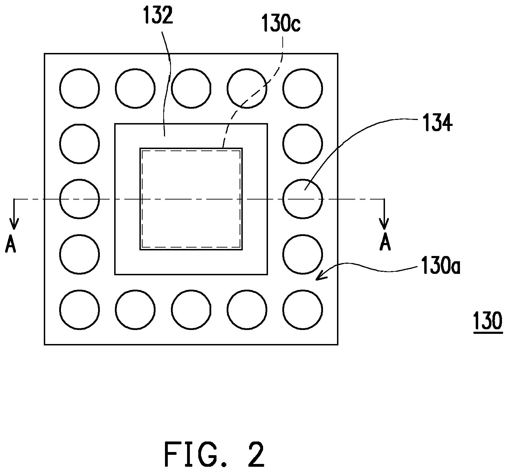

FIG. 2 is a schematic top view illustrating a sensing device of FIG. 1A. More particularly, the cross section of the sensing device in FIG. 1A is corresponded to the cross-sectional line A-A of FIG. 2. Referring to FIG. 1A and Fig. 2, next, a front surface 130a of the sensing device 130 is adhered on the adhesive layer 110, so as to position the sensing device 130 in the middle opening 120a. The sensing device 130 has a sensing region 130c located at the front surface 130a, a blocking pattern 132 located at the front surface 130a and surrounded the sensing region 130c, and at least one electrode 134 located at the front surface 130a and outside the blocking pattern 132. The sensing region 130c is a region being utilized to receive optical or acoustical signals. The blocking pattern 132 is utilized to decrease the probability of the sensing region 130c of the sensing device 130 being damaged during the subsequent fabrication process. The electrode 134 is utilized to receive the electric power for driving the sensing device 130. In the embodiment, the sensing device 130 may be an optical sensing device (such as an image capturing device) or an acoustical sensing device, but the invention is not limited thereto.

Referring to FIG. 1B, next, a back dielectric layer 140 is formed on a posterior surface 120b of the middle dielectric layer 120 and a back surface 130b opposite to the front surface 130a of the sensing device 130, so as to fix the sensing device 130 in the middle opening 120a of the middle dielectric layer 120. In the embodiment, the back dielectric layer 140 may completely cover the back surface 130b of the sensing device 130 and the posterior surface 120b of the back dielectric layer 140. In addition, a portion 142 of the back dielectric layer 140 may ulteriorly extend between the middle opening 120a and the sensing device 130. In the embodiment, the material of the back dielectric layer 140 is, for example, a high molecular polymer, but the invention is not limited thereto.

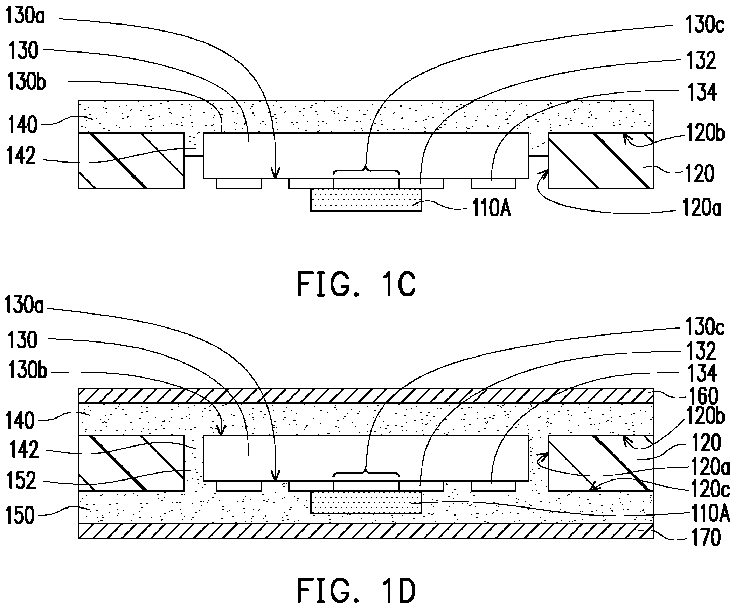

Referring to FIG. 1B and FIG. 1C, next, the adhesive layer 110 is patterned (illustrated in FIG. 1B) to form a patterned adhesive layer 110A (illustrated in FIG. 1C), wherein the patterned adhesive layer 110A covers the sensing region 130c and least parts of the blocking pattern 132, and exposes the electrode 134 and the middle dielectric layer 120. More specifically, in the embodiment, a laser may be utilized first to divide the adhesive layer 110 along the blocking pattern 132. Then, the parts of the non-covered sensing region 130c of the adhesive layer 110 are removed, so as to form the patterned adhesive layer 110A. It should be noticed that the patterned adhesive layer 110A covering the sensing region 130c may provide the protection function to the sensing region 130c of the sensing device 130 during the subsequent fabrication process, so that each layer formed afterwards may not be in contact with the sensing region 130c easily. More specifically, a gap may be existed between the patterned adhesive layer 110A and the sensing region 130c. This means that the patterned adhesive layer 110A may not be in contact with the sensing region 130c, therefore, each layer formed on the patterned adhesive layer 110A during the subsequent fabrication process may separate from the sensing region 130c through the patterned adhesive layer 110A to avoid easily creating damages on the sensing region 130c.

Referring to FIG. 1D, next, a front dielectric layer 150 is formed on an anterior surface 120c of the middle dielectric layer 120, the front surface 130a of the sensing device 130 and the patterned adhesive layer 110A, but the front dielectric layer 150 is blocked by the blocking pattern 132 and the patterned adhesive layer 110A, and thus the sensing region 130c of the sensing device 130 is not covered. In the embodiment, a portion 152 of the front dielectric layer 150 may ulteriorly extend between the middle opening 120a and the sensing device 130. The portion 152 of the front dielectric layer 150 may directly connect with a portion 142 of the back dielectric layer 140. In the embodiment, the material of the front dielectric layer 150 is, for example, a high molecular polymer, but the invention is not limited thereto.

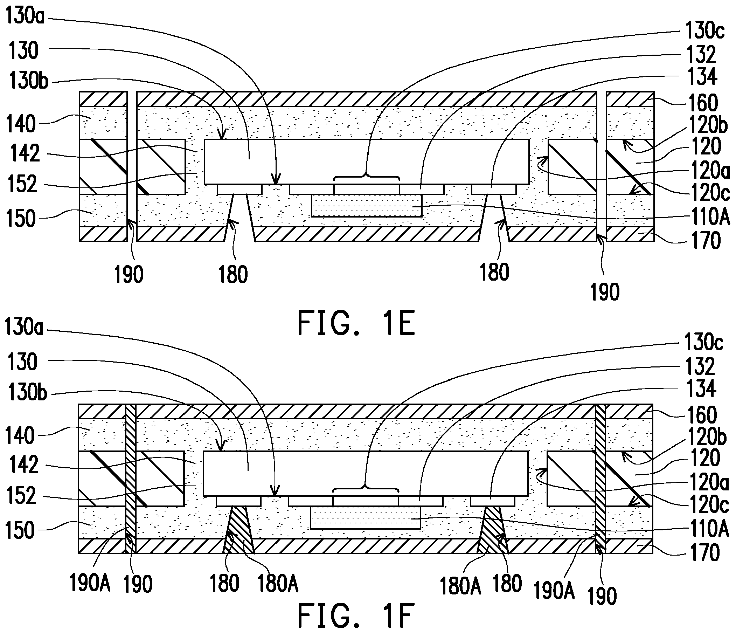

Continuing to refer to FIG. 1D, in the embodiment, a back conductive layer 160 and a front conductive layer 170 may be respectively formed on the back dielectric layer 140 and the front dielectric layer 150. The back conductive layer 160 of the embodiment may completely cover the back dielectric layer 140. The front conductive layer 170 of the embodiment may completely cover the front dielectric layer 150. Referring to FIG. 1E and FIG. 1F, next, at least one front conductive via 180A is formed (illustrated in FIG. 1F), and the front conductive via 180A penetrates through the front dielectric layer 170 to connect to the electrode 134. More specifically, in the embodiment, as illustrated in FIG. 1E, at least one opening 180 may firstly be formed in the front conductive layer 170 and the front dielectric layer 150, and the opening 180 exposes the electrode 134. As illustrated in FIG. 1F, then, a conductive material may be filled in the opening 180 to form a front conductive via 180A. In the embodiment, an electroplating process may be utilized to form the front conductive via 180A. The front conductive via 180A connects the front conductive layer 170 and the electrode 134.

Continuing to refer to FIG. 1E and FIG. 1F, the method of the embodiment may further comprise the following steps. As illustrated in FIG. 1E, at least one through hole 190 may be formed in the back conductive layer 160, the back dielectric layer 140, the middle dielectric layer 120, the front dielectric layer 150 and the front conductive layer 170. The through hole 190 penetrates through the back conductive layer 160, the back dielectric layer 140, the middle dielectric layer 120, the front dielectric layer 150 and the front conductive layer 170. As illustrated in FIG. 1F, next, at least one through conductive via 190A is formed in the at least one through hole 190. The through conductive via 190A penetrates through the back conductive layer 160, the back dielectric layer 140, the middle dielectric layer 120, the front dielectric layer 150 and the front conductive layer 170. In the embodiment, the electroplating process may be utilized to form the through conductive via 190A. The through conductive via 190A connects to the back conductive layer 160 and the front conductive layer 170.

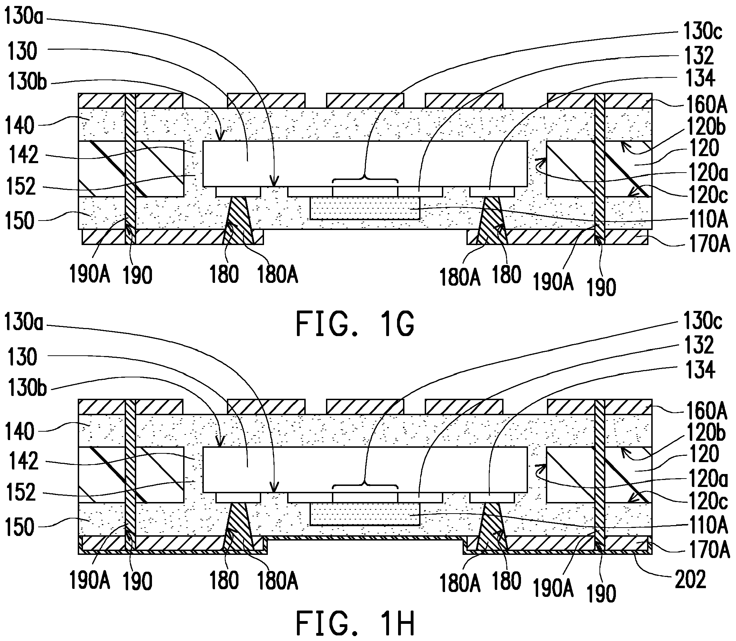

Referring to FIG. 1G, next, a front patterned conductive layer 170A is formed on the front dielectric layer 150 to connect the front conductive via 180A. More specifically, the front conductive layer 170 may be patterned, so as to form the front patterned conductive layer 170A. The front conductive layer 170 already connects with the front conductive via 180A before being patterned, and the front conductive layer 170 after being patterned (that is, the front patterned conductive layer 170A) also connects with the front conductive via 180A. In the embodiment, while forming the front patterned conductive layer 170A, together with, a back patterned conductive layer 160A may be formed on the back dielectric layer 140. More specifically, the back conductive layer 160 may be patterned, so as to form the back patterned conductive layer 160A. In the embodiment, the back conductive layer 160 and the front conductive layer 170 already connect with the through conductive via 190A before being patterned, and the back conductive layer 160 and the front conductive layer 170 after being patterned (that is, the back patterned conductive layer 160A and the front patterned conductive layer 170A) also connect with the through conductive via 190A.

Referring to FIG. 1H, next, in the embodiment, a solder mask layer 202 may be selectively formed on the front dielectric layer 150 and the front patterned conductive layer 170A. In the embodiment, the solder mask layer 202 may completely cover the front dielectric layer 150 and the front patterned conductive layer 170A.

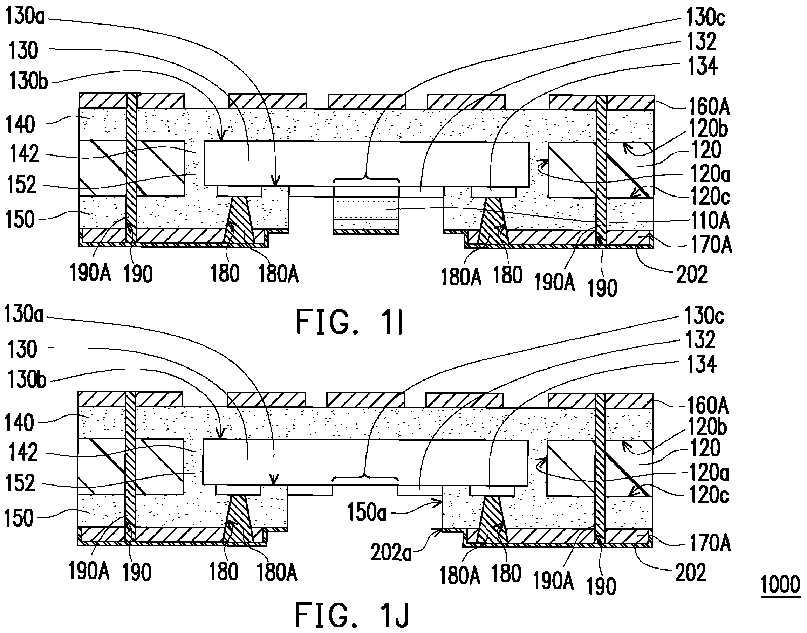

Referring to FIG. 1I, next, a laser (not illustrated) is utilized to divide the front dielectric layer 150 and the patterned adhesive layer 110A along the blocking pattern 132. Referring to FIG. 1J, then, the patterned adhesive layer 110A and the parts of the front dielectric layer 150 thereon are removed, so as to expose the sensing region 130c. Referring to FIG. 1I, in the embodiment, in the step of dividing the front dielectric layer 150, the laser may simultaneously be utilized to divide the solder mask layer 202, the front dielectric layer 150 and the patterned adhesive layer 110A. Referring to FIG. 1J, in the embodiment, in the step of removing the patterned adhesive layer 110A and the parts of the front dielectric layer 150 thereon, the patterned adhesive layer 110A, the parts of the front dielectric layer 150 thereon and the parts of the solder mask layer 202 thereon may simultaneously be removed to expose the sensing region 130c. Accordingly, a sensing device package structure 1000 of the embodiment is completed.

In the method of the embodiment, it should be noted that since the sensing device 130 is embedded within the middle dielectric layer 120, the sensing device package structure 1000 fabricated by the method of the embodiment may have thin overall thickness and small volume. In addition, in the method of the embodiment, the laser is utilized to divide the front dielectric layer 150 and the patterned adhesive layer 110A along the blocking pattern 132, thereby removing the patterned adhesive layer 110A and the parts of the front dielectric layer 150 thereon to expose the sensing region 130c. Therefore, the sensing region 130c of the sensing device 130 may not be damaged easily during the process of dividing and removing the parts of the front dielectric layer 150 and the patterned adhesive layer 110A, thereby increasing the production yield of the sensing device package structure 1000 of the embodiment.

### Sensing device package structure

Referring to FIG. 1I, the sensing device package structure 1000 of the embodiment comprises a middle dielectric layer 120, a sensing device 130, a front dielectric layer 150, a front patterned conductive layer 170A and at least one front conductive via 180A.

The middle dielectric layer 120 has an anterior surface 120c, a posterior surface 120b opposite to the anterior surface 120c, and a middle opening 120a connecting the anterior surface 120c and the posterior surface 120b. The sensing device 130 is disposed in the middle opening 120a. The sensing device 130 has a front surface 130a, a back surface 130b opposite to the front surface 130a, a sensing region 130c located at the front surface 130a, a blocking pattern 132 located at the front surface 130a and surrounded the sensing region 130c, and at least one electrode 134 located at the front surface 130a and outside the blocking pattern 132. In the embodiment, the sensing device 130 may be an optical sensing device or an acoustical sensing device, but the invention is not limited thereto.

The front dielectric layer 150 is disposed on the anterior surface 120c of the middle dielectric layer 120 and the front surface 130a of the sensing device 130. The front dielectric layer 150 has a front opening 150a exposed the sensing region 130c and the blocking pattern 132. In the embodiment, a portion 152 of the front dielectric layer 150 may extend between the middle opening 120a and the sensing device 130. The front patterned conductive layer 170A is disposed on the front dielectric layer 150. The at least one front conductive via 180A penetrates through the front dielectric layer 150 and connects the front patterned conductive layer 170A and the electrode 134.

The sensing device package structure 1000 of the embodiment may further comprise a back dielectric layer 140. The back dielectric layer 140 may be disposed on the posterior surface 120b of the middle dielectric layer 120 and the back surface 130b opposite to the front surface 130a of the sensing device 130. In the embodiment, a portion 142 of the back dielectric layer 140 may extend between the middle opening 120a and the sensing device 130. More specifically, the portion 142 of the back dielectric layer 140 may directly connect with the portion 152 of the front dielectric layer 150.

The sensing device package structure 1000 of the embodiment further comprises a back patterned conductive layer 160A. The back patterned conductive layer 160A is disposed on the back dielectric layer 140. The sensing device package structure 1000 of the embodiment further comprises at least one through conductive via 190A. The through conductive via 190A penetrates through the front dielectric layer 150, the middle dielectric layer 120 and the back dielectric layer 140, and connects the front patterned conductive layer 170A and the back patterned conductive layer 160A. The sensing device package structure 1000 of the embodiment further comprises a solder mask layer 202. The solder mask layer 202 is disposed on the front dielectric layer 150 and the front patterned conductive layer 170A. The solder mask layer 202 has an opening 202a. The opening 202a exposes the sensing region 130c and the blocking pattern 132. In the embodiment, the opening 202a may be flush with the front opening 150a.

In the sensing device package structure 1000 of the embodiment, it should be noted that since the sensing device 130 is embedded within the middle dielectric layer 120, the sensing device package structure 1000 may have thin overall thickness and small volume.

According to the above description, the method of an embodiment of the invention may fabricate a sensing device package structure with thin overall thickness and small volume by embedding the sensing device within the middle dielectric layer. In addition, in the method, the laser is utilized to divide the front dielectric layer and the patterned adhesive layer along the blocking pattern, thereby removing the patterned adhesive layer and the parts of the front dielectric layer thereon to expose the sensing region. Therefore, the sensing region of the sensing device may not be damaged easily during the process of dividing and removing the parts of the front dielectric layer and the patterned adhesive layer, thereby increasing the production yield of the sensing device package structure.

## Claims

1. A sensing device package structure (1000), comprising:
a middle dielectric layer (120) having an anterior surface (120c), a posterior surface (120b) opposite to the anterior surface (120c) and a middle opening (120a) connecting to the anterior surface (120c) and the posterior surface (120b);
a sensing device (130) disposed in the middle opening (120a), wherein the sensing device (130) has a front surface (130a), a back surface (130b) opposite to the front surface (130a), a sensing region (130c) located at the front surface (130a), a laser blocking pattern (132) located at the front surface (130a) and surrounded the sensing region (130c), and at least one electrode (134) located at the front surface (130a) and outside the laser blocking pattern (132);
a front dielectric layer (150) disposed on the anterior surface (120c) of the middle dielectric layer (120) and the front surface (130a) of the sensing device (130) and having a front opening (150a) exposed the sensing region (130c) and the laser blocking pattern (132);
a front patterned conductive layer (170A) disposed on the front dielectric layer (150); and
at least one front conductive via (180A) penetrating through the front dielectric layer (150) and connecting the front patterned conductive layer (170A) and the electrode (134), **characterized in that**
the laser blocking pattern (132) protrudes from the front surface (130a) of the sensing device (130) and that the laser blocking pattern (132) and the sensing region (130c) are directly exposed to an outside.

2. The sensing device package structure (1000) as recited in claim 1, wherein the sensing device (130) is an optical sensing device or an acoustical sensing device.

3. The sensing device package structure (1000) as recited in claim 1, wherein a portion of the front dielectric layer (150) extends between the middle opening (120a) and the sensing device (130).

4. The sensing device package structure (1000) as recited in claim 1 or claim 2, further comprising:
a back dielectric layer (140) disposed on the posterior surface (120b) of the middle dielectric layer (120) and a back surface (130b) opposite to the front surface (130a) of the sensing device (130).

5. The sensing device package structure (1000) as recited in claim 4, wherein a portion of the back dielectric layer (140) extends between the middle opening (120a) and the sensing device (130).

6. The sensing device package structure (1000) as recited in claim 4, further comprising:
a back patterned conductive layer (160A) disposed on the back dielectric layer (140).

7. The sensing device package structure (1000) as recited in claim 4, further comprising:
at least one through conductive via (190A) penetrating through the front dielectric layer (150), the middle dielectric layer (120) and the back dielectric layer (140) and connecting the front patterned conductive layer (170A) and the back patterned conductive layer (160A).
